# EUROPEAN PATENT SPECIFICATION

(11) **EP 3 468 072 B1**
(45) Date of publication and mention of the grant of the patent: **20.05.2026**
(21) Application number: 16909221.0
(22) Date of filing: 21.07.2016
(51) Int. Cl.: H04B 10/572, H04B 10/50, H04J 14/02, H01S 5/06

(54) **WAVELENGTH SHIFT CONTROL METHOD AND SYSTEM**
WELLENLÄNGENVERSCHIEBUNGSVERFAHREN UND -SYSTEM
PROCÉDÉ ET SYSTÈME DE RÉGULATION DU DÉCALAGE DE LONGUEUR D'ONDE

(43) Date of publication of application: 10.04.2019
(73) Proprietor: Huawei Technologies Co., Ltd., Longgang District Shenzhen, Guangdong 518129 (CN)
(72) Inventor: WU, Xuming, Shenzhen, Guangdong 518129 (CN); LIN, Huafeng, Shenzhen, Guangdong 518129 (CN); FANG, Liming, Shenzhen, Guangdong 518129 (CN)
(74) Representative: Goddar, Heinz J.
(86) International application number: PCT/CN2016/090868
(87) International publication number: WO 2018/014294

(56) References cited:
- EP-A1- 2 804 335
- CN-A- 101 888 269
- CN-A- 104 539 370
- CN-A- 105 324 703
- US-A- 5 515 391
- US-A1- 2013 107 900
- US-A1- 2015 063 812
- US-A1- 2015 063 812
- US-A1- 2015 381 300
- US-A1- 2016 127 045
- US-B1- 9 246 307

## Description

### TECHNICAL FIELD

The present invention relates to the optical communications field, and in particular, to a wavelength shift control method and system.

### BACKGROUND

A broadband access technology develops rapidly in recent years. A passive optical network (English full name: Passive Optical Network, PON for short) system has been widely popularized and rapidly expanded. An access network requires low costs. In view of this, an access technology with low costs is a main development direction. A wavelength division multiplexing manner is mainly used in the access technology with low costs to implement a high-capacity PON system. For example, an uplink and a downlink of a typical PON system both include four wavelength paths. A 100 GHz distance exists between every two adjacent wavelength paths. Coexistence between wavelengths is implemented by using a wavelength multiplexer (English full name: Wavelength Multiplexer, WM for short). The PON system is a point-to-multipoint system. Each optical line terminal (English full name: Optical Line Terminal, OLT for short) in the PON system needs to be connected to uplink and downlink services of a plurality of optical network units (English full name: Optical Network Unit, ONU for short). To avoid a conflict between uplink services of the ONU, the PON system works on an uplink in a time division multiplexing manner. After the OLT performs scheduling, only one ONU is allowed to send an uplink service at a moment, and a transmitter needs to be immediately closed after the uplink service is sent, to ensure that work of a next ONU is not interfered. This working mode of the ONU is referred to as a burst transmission mode. When the ONU is in the burst transmission mode, because a drive current is instantaneously added to a laser chip, the drive current causes temperature of the laser chip to rise. After the temperature of the laser chip becomes stable, if a laser is turned off, the temperature of the laser chip is lowered, and then, the temperature of the laser chip changes, causing a shift to a transmit wavelength of the laser. This affects normal work of the ONU and another ONU of an adjacent path. In other words, a wavelength shift affects normal work of a PON system with a plurality of wavelength paths.

A current method for eliminating impact caused by a wavelength shift is as follows: A drive current is reduced to reduce a wavelength shift amount because the wavelength shift amount is directly proportional to the drive current of the laser, to reduce the impact caused by the wavelength shift.

However, if the drive current is reduced, a transmission function of the laser is affected, and the PON system has a relatively high requirement for a transmit power of the laser. Therefore, reducing the drive current affects the normal work of the PON system. It can be learned that the method cannot well eliminate the impact caused by the wavelength shift on the normal work of the PON system with a plurality of wavelength paths.

US 9,246,307 B1 discloses: an apparatus comprising a burst-mode laser comprising an active layer and configured to emit an optical signal during a burst period, wherein a temperature change of the burst-mode laser causes the optical signal to shift in wavelength, and a heater thermally coupled to the active layer and configured to reduce a wavelength shift of the optical signal during the burst period by applying heat to the active layer based on timing of the burst period.

US 2016/127045 A1 discloses: a bias point of an external modulator is set to different values according to on and off of a burst control signal and an optical source is driven continuously in a burst optical signal transmission device. The burst optical signal transmission device avoid generation of transient fluctuation of a wavelength and a light amount at the time of burst signal rising.

US 2015/0063812 A1 discloses: an optical node comprises a tunable optical transceiver having a laser and a temperature element. The optical node also comprises a wavelength shift stabilization circuit configured to adjust current provided to the temperature element such that wavelength shifts, due to changes in a drive current applied to the tunable optical transceiver, are reduced.

US 5 515 391 A discloses: a laser diode package incorporating a first laser diode (or diode laser array) for providing a modulated light output and a second laser diode (or diode laser array) with substantially similar thermal operating characteristics which is modulated with a complementary current signal relative to the modulated current signal driving the first laser diode. The two laser diodes are mounted in close proximity to one another on a temperature controlled heat sink. For diode laser arrays, slots are provided in the heat sink between adjacent array elements. The complementary modulation of corresponding elements in each laser diode ensures that the combined heat generation by each such corresponding pair of elements is constant in time. In the case of digital modulation, the driver logic and current drivers providing the complementary modulation signals may be a modulation controlled switch routing a constant current to one or the other of each corresponding pair of laser elements.

US 2013/0107900 A1 discloses a light emitting device including a semiconductor laser, which oscillates in a single longitudinal mode, formed above a semiconductor substrate, a first heater, which controls a temperature of the semiconductor laser, provided near the semiconductor laser, a gain unit, which amplifies a beam outputted from the semiconductor laser and outputs an amplified beam, formed above the semiconductor substrate, a second heater, which controls a temperature of the gain unit, provided near the gain unit, and a second harmonic generation element, which converts the amplified beam outputted from the gain unit to a second harmonic light and outputs the second harmonic light.

### SUMMARY

The present invention is defined by the independent claims. Specific embodiments are defined by the dependent claims. Embodiments which do not fall within the scope of the claims are examples for understanding the present invention.

In view of this, a first example of the present invention provides a wavelength shift control method. The method is applied to a wavelength shift control system. The system includes Media Access Control MAC, a controller, and a transmitter. The transmitter includes a laser and a heater, and the laser fits the heater. Heat conducted by the heater to the laser when a switch of the heater is turned on matches heat of the laser when a switch of the laser is turned off. The method includes: generating, by the MAC, a burst control signal; sending, by the MAC, the burst control signal to the controller; and controlling, by the controller, switch statuses of the laser and the heater according to the received burst control signal, where when the switch of the laser is in an on state, the switch of the heater is in an off state, and when the switch of the laser is in an off state, the switch of the heater is in an on state, so that temperature of the laser remains stable.

The switch of the laser and the switch of the heater are both controlled by using the burst control signal, to implement stable control over the temperature of the laser, ensure that a transmit wavelength of the laser is stable in a burst work process of a transmitter and is not shifted, and avoid impact on normal work of a PON system with a plurality of wavelength paths. This is different from the prior art.

In some possible implementations, the controlling, by the controller, switch statuses of the laser and the heater according to the received burst control signal includes: controlling, by the controller, the switch statuses of the laser and the heater according to a high or low level of the received burst control signal, where when a level of the burst control signal is a high level, the switch of the laser is in the on state, and when a level of the burst control signal is a low level, the switch of the laser is in the off state; or when a level of the burst control signal is a low level, the switch of the laser is in the off state, and when a level of the burst control signal is a high level, the switch of the laser is in the on state.

The switch of the laser and the switch of the heater are both controlled by using the high or low level of the burst control signal, to implement stable control over the temperature of the laser, ensure that the laser and the heater alternately work, ensure that a transmit wavelength of the laser is stable in a burst work process of a transmitter and is not shifted, and avoid impact on normal work of a PON system with a plurality of wavelength paths. This is different from the prior art.

In other possible implementations, the controller includes a laser current controller and a heater current controller, and the controlling, by the controller, switch statuses of the laser and the heater according to the received burst control signal includes: turning on, by the laser current controller, a current switch of the laser according to the received burst control signal, and turning off, by the heater current controller, a current switch of the heater according to the received burst control signal; or turning off, by the laser current controller, a current switch of the laser according to the received burst control signal, and turning on, by the heater current controller, a current switch of the heater according to the received burst control signal.

The transmitter may further include a semiconductor cooler, and the transmitter controls overall temperature inside the transmitter by using the semiconductor cooler, to ensure that the overall temperature inside the transmitter does not change. This is different from the prior art. In addition, the controller includes the laser current controller and the heater current controller. The laser current controller is configured to provide a drive current for the laser, and the heater current controller is configured to provide a drive current for the heater. According to the burst control signal, the drive current of the laser is enabled or disabled by controlling the laser current controller, and the drive current of the heater is enabled or disabled by controlling the heater current controller, to ensure that the heater and the laser alternately work.

In other possible implementations, the controller includes a laser current controller and a current switching switch connected to the laser current controller, the current switching switch is configured to connect to an input end of the laser or an input end of the heater, and the controlling, by the controller, switch statuses of the laser and the heater according to the received burst control signal includes: switching, by the laser current controller, the current switching switch to the input end of the laser according to the received burst control signal; or switching, by the laser current controller, the current switching switch to the input end of the heater according to the received burst control signal.

The drive current of the laser and the drive current of the controller are both provided by the laser current controller. This is different from the prior art. When the laser needs to be turned on, the current switching switch is connected to the input end of the laser. In this case, the laser works. When the laser needs to be turned off, the current switching switch is connected to the input end of the heater. In this case, the drive current of the laser is disconnected, and the heater works. In an actual application, the heater may select a resistor connected in parallel for current division, and a size of the drive current of the heater may be adjusted by using the resistor connected in parallel. Alternatively, the heater may be serially connected to a proportional current divider, and a size of the drive current of the heater may be adjusted by using the proportional current divider.

In other possible implementations, the controller is a controller in a primary path of the system, the transmitter is a transmitter in the primary path of the system, and the method further includes: after the primary path is faulty, generating, by the MAC, a protection path control signal; sending, by the MAC, the protection path control signal to a controller in a preset protection path; and controlling, by the controller in the protection path, switch statuses of a laser and a heater in the protection path according to the received protection path control signal, where when a switch of the laser in the protection path is in an on state, the heater in the protection path is in an off state, and when a switch of the laser in the protection path is in an off state, the heater in the protection path is in an on state, so that temperature of the laser in the protection path remains stable.

To ensure stable performance of the system, the protection path is usually reserved on an OLT side. Usually, a transmitter of the protection path is turned off. When the PON system detects that the primary path is faulty, the protection path is initiated, and the MAC generates the protection path control signal and sends the protection path control signal to the controller in the protection path. This is different from the prior art.

In other possible implementations, the controller provides a drive current of the heater and a drive current of the laser.

In other possible implementations, a ratio of a value for the drive current of the heater to a value for the drive current of the laser is a preset threshold.

A second example of the present invention further provides a wavelength shift control method. The method is applied to a wavelength shift control system. The system includes Media Access Control MAC, a controller, and a transmitter. The transmitter includes a laser, a heater, and an optical amplifier, and the laser fits both the heater and the optical amplifier. Heat conducted by the heater to the laser when a switch of the heater is turned on matches heat conducted by the optical amplifier to the laser when a switch of the optical amplifier is turned on. The method includes: generating, by the MAC, a burst control signal; sending, by the MAC, the burst control signal to the controller; and controlling, by the controller, switch statuses of the heater and the optical amplifier according to the received burst control signal, where when the switch of the heater is in an on state, the switch of the optical amplifier is in an off state, and when the switch of the heater is in an off state, the switch of the optical amplifier is in an on state, so that temperature of the laser remains stable.

The heater and the optical amplifier alternatively work, to ensure that the temperature of the laser does not change, avoiding a wavelength shift. This is different from the prior art.

In some possible implementations, the controller provides a drive current of the heater and a drive current of the optical amplifier.

In other possible implementations, a ratio of a value for the drive current of the heater to a value for the drive current of the optical amplifier is a preset threshold.

A third example of the present invention further provides a wavelength shift control system. The system includes: Media Access Control MAC, a controller, and a transmitter. The transmitter includes a laser and a heater, and the laser fits the heater. Heat conducted by the heater to the laser when a switch of the heater is turned on matches heat of the laser when a switch of the laser is turned off. The MAC is used to: generate a burst control signal, and send the burst control signal to the controller. The controller is configured to control switch statuses of the laser and the heater according to the received burst control signal, where when the switch of the laser is in an on state, the switch of the heater is in an off state, and when the switch of the laser is in an off state, the switch of the heater is in an on state, so that temperature of the laser remains stable.

The switch of the laser and the switch of the heater are both controlled by using the burst control signal, to implement stable control over the temperature of the laser, ensure that a transmit wavelength of the laser is stable in a burst work process of a transmitter and is not shifted, and avoid impact on normal work of a PON system with a plurality of wavelength paths. This is different from the prior art.

In some possible implementations, the controller is specifically configured to control the switch statuses of the laser and the heater according to a high or low level of the received burst control signal, where when a level of the burst control signal is a high level, the switch of the laser is in the on state, and when a level of the burst control signal is a low level, the switch of the laser is in the off state; or when a level of the burst control signal is a low level, the switch of the laser is in the off state, and when a level of the burst control signal is a high level, the switch of the laser is in the on state. The switch of the laser and the switch of the heater are both controlled by using the high or low level of the burst control signal, to implement stable control over the temperature of the laser, ensure that the laser and the heater alternately work, ensure that a transmit wavelength of the laser is stable in a burst work process of a transmitter and is not shifted, and avoid impact on normal work of a PON system with a plurality of wavelength paths. This is different from the prior art.

In other possible implementations, the controller includes a laser current controller and a heater current controller, the laser current controller is configured to turn on a current switch of the laser according to the received burst control signal, and the heater current controller is configured to turn off a current switch of the heater according to the received burst control signal; or the laser current controller is configured to turn off a current switch of the laser according to the received burst control signal, and the heater current controller is configured to turn on a current switch of the heater according to the received burst control signal.

The transmitter may further include a semiconductor cooler, and the transmitter controls overall temperature inside the transmitter by using the semiconductor cooler, to ensure that the overall temperature inside the transmitter does not change. This is different from the prior art. In addition, the controller includes the laser current controller and the heater current controller. The laser current controller is configured to provide a drive current for the laser, and the heater current controller is configured to provide a drive current for the heater. According to the burst control signal, the drive current of the laser is enabled or disabled by controlling the laser current controller, and the drive current of the heater is enabled or disabled by controlling the heater current controller, to ensure that the heater and the laser alternately work.

In other possible implementations, the controller includes a laser current controller and a current switching switch connected to the laser current controller, the current switching switch is configured to connect to an input end of the laser or an input end of the heater, the laser current controller is configured to switch the current switching switch to the input end of the laser according to the received burst control signal, or the laser current controller is configured to switch the current switching switch to the input end of the heater according to the received burst control signal.

The drive current of the laser and the drive current of the controller are both provided by the laser current controller. This is different from the prior art. When the laser needs to be turned on, the current switching switch is connected to the input end of the laser. In this case, the laser works. When the laser needs to be turned off, the current switching switch is connected to the input end of the heater. In this case, the drive current of the laser is disconnected, and the heater works. In an actual application, the heater may select a resistor connected in parallel for current division, and a size of the drive current of the heater may be adjusted by using the resistor connected in parallel. Alternatively, the heater may be serially connected to a proportional current divider, and a size of the drive current of the heater may be adjusted by using the proportional current divider.

In other possible implementations, there is a current divider on a link of the heater.

In other possible implementations, the controller is a controller in a primary path of the system, the transmitter is a transmitter in the primary path of the system, the MAC is further configured to: after the primary path is faulty, generate a protection path control signal, and send the protection path control signal to a controller in a preset protection path, the system further includes the controller in the protection path, and the controller in the protection path is configured to control switch statuses of a laser and a heater in the protection path according to the received protection path control signal, where when a switch of the laser in the protection path is in an on state, the heater in the protection path is in an off state, and when a switch of the laser in the protection path is in an off state, the heater in the protection path is in an on state, so that temperature of the laser in the protection path remains stable.

To ensure stable performance of the system, the protection path is usually reserved on an OLT side. Usually, a transmitter of the protection path is turned off. When the PON system detects that the primary path is faulty, the protection path is initiated, and the MAC generates the protection path control signal and sends the protection path control signal to the controller in the protection path. This is different from the prior art.

In other possible implementations, the controller provides a drive current of the heater and a drive current of the laser.

In other possible implementations, a ratio of a value for the drive current of the heater to a value for the drive current of the laser is a preset threshold.

A fourth example of the present invention further provides a wavelength shift control system. The system includes Media Access Control MAC, a controller, and a transmitter. The transmitter includes a laser, a heater, and an optical amplifier, and the laser fits both the heater and the optical amplifier. Heat conducted by the heater to the laser when a switch of the heater is turned on matches heat conducted by the optical amplifier to the laser when a switch of the optical amplifier is turned on. The MAC is used to: generate a burst control signal, and send the burst control signal to the controller. The controller is configured to control switch statuses of the heater and the optical amplifier according to the received burst control signal, where when the switch of the heater is in an on state, the switch of the optical amplifier is in an off state, and when the switch of the heater is in an off state, the switch of the optical amplifier is in an on state, so that temperature of the laser remains stable.

The heater and the optical amplifier alternatively work, to ensure that the temperature of the laser does not change, avoiding a wavelength shift. This is different from the prior art.

In some possible implementations, the controller provides a drive current of the heater and a drive current of the optical amplifier.

In other possible implementations, a ratio of a value for the drive current of the heater to a value for the drive current of the optical amplifier is a preset threshold.

In the technical solutions provided in embodiments of the present invention, the switch of the laser and the switch of the heater are both controlled by using the burst control signal. When the heat conducted by the heater to the laser when the switch of the heater is turned on matches the heat of the laser when the switch of the laser is turned off, this implements stable control over the temperature of the laser, ensures that the transmit wavelength of the laser is stable in the burst work process of a transmitter and is not shifted, and avoid the impact on the normal work of the PON system with a plurality of wavelength paths.

### BRIEF DESCRIPTION OF DRAWINGS

FIG. 1 is a schematic diagram of an internal structure of a transmitter with a heater according to an embodiment of the present invention;
FIG. 2 is a schematic diagram of an embodiment of a wavelength shift control method according to an embodiment of the present invention;
FIG. 3 is a schematic diagram of control of a specific burst control signal according to an embodiment of the present invention;
FIG. 4 is a schematic diagram of another embodiment of a wavelength shift control method according to an embodiment of the present invention;
FIG. 5 is a schematic structural diagram of a wavelength shift control system according to an embodiment of the present invention;
FIG. 6 is a schematic structural diagram of a circuit in which a drive current of a laser is proportional to a drive current of a heater according to an embodiment of the present invention;
FIG. 7 is another schematic structural diagram of a wavelength shift control system according to an embodiment of the present invention;
FIG. 8 is another schematic structural diagram of a wavelength shift control system according to an embodiment of the present invention;
FIG. 9 is a schematic structural diagram of a wavelength shift control system of a protection path according to an embodiment of the present invention;
FIG. 10 is another schematic structural diagram of a wavelength shift control system of a protection path according to an embodiment of the present invention;
FIG. 11 is another schematic structural diagram of a wavelength shift control system according to an embodiment of the present invention; and
FIG. 12 is a schematic structural diagram of a circuit in which a drive current of a heater is proportional to a drive current of an optical amplifier according to an embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by persons skilled in the art based on the embodiments of the present invention without creative efforts shall fall within the protection scope of the present invention.

In the specification, claims, and accompanying drawings of the present invention, the terms "first", "second", "third", "fourth", and the like (if exist) are intended to distinguish between similar objects but do not necessarily indicate a specific order or sequence. It should be understood that the data termed in such a way are interchangeable in proper circumstances so that the embodiments described herein can be implemented in other orders than the order illustrated or described herein. Moreover, the terms "include", "contain" and any other variants mean to cover the non-exclusive inclusion, for example, a process, method, system, product, or device that includes a list of steps or units is not necessarily limited to those expressly listed steps or units, but may include other steps or units not expressly listed or inherent to such a process, method, system, product, or device.

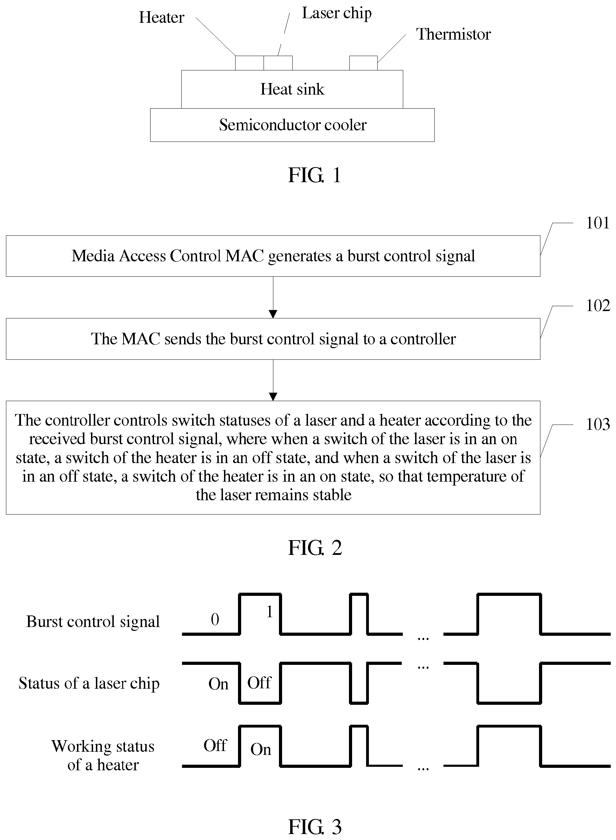

In the embodiments of the present invention, a heater is placed inside a transmitter, for example, a resistive heater. The heater fits a laser chip. A switch of a laser and a switch of the heater are both controlled by using a burst control signal, to implement stable control over temperature of the laser, ensure that a transmit wavelength of the laser is stable in a burst work process of a transmitter and is not shifted, and avoid impact on normal work of a PON system with a plurality of wavelength paths. An embodiment of the present invention provides a schematic diagram of an internal structure of a transmitter with a heater. As shown in FIG. 1, a semiconductor cooler, a heat sink, and a thermistor are used to keep overall temperature inside the transmitter unchanged through controlling. The heater and the laser chip may be integrated on a chip, or the transmitter may be placed next to the laser chip in an encapsulation process. The transmitter with the heater needs to complete control over the semiconductor cooler, control over the laser chip, and control over the heater during burst work.

The following describes a wavelength shift control method in the embodiments of the present invention with reference to specific embodiments and accompanying drawings.

Referring to FIG. 2, an embodiment of a wavelength shift control method in embodiments of the present invention includes the following steps.

101. Media Access Control MAC generates a burst control signal.

In this embodiment, the burst control signal may be generated by the MAC of an ONU end of a PON system based on scheduling of an OLT.

102. The MAC sends the burst control signal to a controller.

In this embodiment, there may be one or more controllers. This is not limited herein. The controller may include one or more sub-controllers, such as a laser current controller and a heater current controller in the following.

103. The controller controls switch statuses of a laser and a heater according to the received burst control signal, where when a switch of the laser is in an on state, a switch of the heater is in an off state, and when a switch of the laser is in an off state, a switch of the heater is in an on state, so that temperature of the laser remains stable. In this embodiment, the burst control signal may be a pulse electrical signal. The pulse electrical signal includes two level statuses (0 and 1). Herein "0" represents a low level, and "1" represents a high level. The two level statuses respectively represent on and off states of the laser.

It should be noted that heat of the laser is related to a drive current of the laser, and heat of the heater is related to a drive current of the heater. A larger drive current indicates more heat. Usually, the drive current of the heater is related to the drive current of the laser. The drive current of the laser is a current required for driving the laser to work, and the drive current of the heater is a current required for driving the heater to work. For a specific laser and a specific heater, a heat conduction relationship between the specific laser and the specific heater is determined. Therefore, as long as it is ensured that heat conducted by the heater to the laser when the switch of the heater is turned on matches (for example, is the same as) heat of the laser when the switch of the laser is turned off, it can be ensured that the temperature of the laser remains stable when the switch of the laser is turned off (the switch of the heater is turned on) and the switch of the laser is turned on (the switch of the heater is turned off). Although heat efficiency of the laser and heat efficiency of the heater may be different, the heat efficiency is positively related to the drive current, for example, in direct proportion. To ensure that the heat conducted by the heater to the laser is consistent with the heat of the laser, usually, it may be ensured that the drive current of the heater is proportional to the drive current of the laser. To be specific, a ratio of a value for the drive current of the heater to a value for the drive current of the laser is a preset threshold. The preset threshold herein is determined based on the heat efficiency and heat conduction efficiency of the laser and the heater, and the preset threshold is determined for the specific laser and the specific heater.

For example, when the switch of the laser is in the off state, in this case, the temperature of the laser is lowered. To ensure that the temperature of the laser remains stable, in this case, the switch of the heater is turned on, so that the temperature of the laser remains stable through heat conduction. Then, when the switch of the laser is in the on state, to ensure that the temperature of the laser remains stable, heating the laser (the heat conduction) needs to be stopped. Therefore, the heater needs to be turned off. In this way, the temperature of the laser can always remain stable, so that no shift is generated.

In this embodiment, the switch of the laser and the switch of the heater are both controlled by using the burst control signal, to implement stable control over the temperature of the laser, ensure that a transmit wavelength of the laser is stable in a burst work process of a transmitter and is not shifted, and avoid impact on normal work of a PON system with a plurality of wavelength paths.

In some embodiments of the present invention, that the controller controls switch statuses of a laser and a heater according to the received burst control signal is specifically:
controlling, by the controller, the switch statuses of the laser and the heater according to a high or low level of the received burst control signal, where when a level of the burst control signal is a high level, the switch of the laser is in the on state, and when a level of the burst control signal is a low level, the switch of the laser is in the off state; or
when a level of the burst control signal is a low level, the switch of the laser is in the off state, and when a level of the burst control signal is a high level, the switch of the laser is in the on state.

Refer to FIG. 3 for a schematic diagram of control over a specific burst control signal. In FIG. 3, when the burst control signal is at a low level 0, the switch of the laser is in the state, and the switch of the heater is in the off state; and when the burst control signal is at a high level 1, the switch of the laser is in the off state, and the switch of the heater is in the on state.

In this embodiment, the switch of the laser and the switch of the heater are both controlled by using a high or low level of the burst control signal, to implement stable control over the temperature of the laser, ensure that the laser and the heater alternately work, ensure that a transmit wavelength of the laser is stable in a burst work process of a transmitter and is not shifted, and avoid impact on normal work of a PON system with a plurality of wavelength paths.

In some embodiments of the present invention, the controller includes the laser current controller and the heater current controller, and that the controller controls switch statuses of a laser and a heater according to the received burst control signal includes:
turning on, by the laser current controller, a current switch of the laser according to the received burst control signal, and turning off, by the heater current controller a current switch of the heater according to the received burst control signal; or
turning off, by the laser current controller, a current switch of the laser according to the received burst control signal, and turning on, by the heater current controller, a current switch of the heater according to the received burst control signal.

In this embodiment, a transmitter may further include a semiconductor cooler, and the transmitter controls overall temperature inside the transmitter by using the semiconductor cooler, to ensure that the overall temperature inside the transmitter does not change. In addition, the controller includes the laser current controller and the heater current controller. The laser current controller is configured to provide a drive current for the laser, and the heater current controller is configured to provide a drive current for the heater. According to the burst control signal, the drive current of the laser is enabled or disabled by controlling the laser current controller, and the drive current of the heater is enabled or disabled by controlling the heater current controller, to ensure that the heater and the laser alternately work.

In some embodiments of the present invention, the controller includes the laser current controller and the current switching switch connected to the laser current controller, the current switching switch is configured to connect to an input end of the laser or an input end of the heater, and that the controller controls switch statuses of a laser and a heater according to the received burst control signal includes:
switching, by the laser current controller, the current switching switch to the input end of the laser according to the received burst control signal; or
switching, by the laser current controller, the current switching switch to the input end of the heater according to the received burst control signal.

In this embodiment, the drive current of the laser and the drive current of the controller are both provided by the laser current controller. When the laser needs to be turned on, the current switching switch is connected to the input end of the laser. In this case, the laser works. When the laser needs to be turned off, the current switching switch is connected to the input end of the heater. In this case, the drive current of the laser is disconnected, and the heater works. In an actual application, the heater may select a resistor connected in parallel for current division, and a size of the drive current of the heater may be adjusted by using the resistor connected in parallel. Alternatively, the heater may be serially connected to a proportional current divider, and a size of the drive current of the heater may be adjusted by using the proportional current divider.

In some embodiments of the present invention, the controller is a controller in a primary path of the system, the transmitter is a transmitter in the primary path of the system, and the method further includes:
after the primary path is faulty, generating, by MAC, a protection path control signal;
sending, by the MAC, the protection path control signal to a controller in a preset protection path; and
controlling, by the controller in the protection path, switch statuses of a laser and a heater in the protection path according to the received protection path control signal, where when a switch of the laser in the protection path is in an on state, the heater in the protection path is in an off state, and when a switch of the laser in the protection path is in an off state, the heater in the protection path is in an on state, so that temperature of the laser in the protection path remains stable.

In this embodiment, to ensure stable performance of the system, the protection path is usually reserved on an OLT side. Usually, a transmitter of the protection path is turned off. When the PON system detects that the primary path is faulty, the protection path is initiated, and the MAC generates the protection path control signal and sends the protection path control signal to the controller in the protection path. A specific operation performed by the controller in the protection path is similar to a specific operation performed by the controller in the primary path. Details are not described herein again.

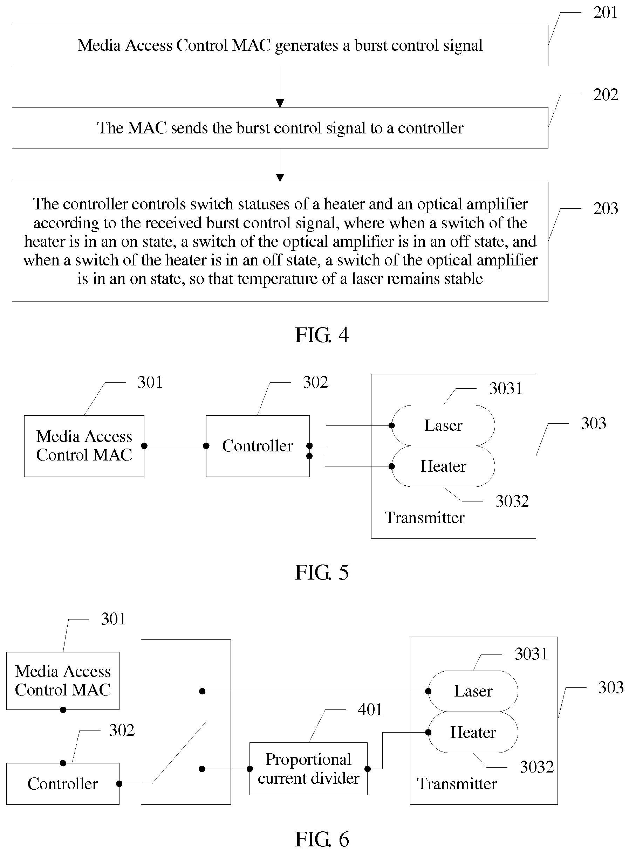

An embodiment of the present invention further provides another wavelength shift control method. Referring to FIG. 4, another embodiment of a wavelength shift control method in embodiments of the present invention includes the following steps. 201. Media Access Control MAC generates a burst control signal.

In this embodiment, the burst control signal of a PON system may be generated by the MAC of an ONU end based on scheduling of an OLT.

202. The MAC sends the burst control signal to a controller.

In this embodiment, there may be one or more controllers. This is not limited herein. The controller may include one or more sub-controllers, such as a laser current controller and a heater current controller.

203. The controller controls switch statuses of a heater and an optical amplifier according to the received burst control signal, where when a switch of the heater is in an on state, a switch of the optical amplifier is in an off state, and when a switch of the heater is in an off state, a switch of the optical amplifier is in an on state, so that temperature of a laser remains stable.

In this embodiment, the laser, the heater, and the optical amplifier are located in a transmitter, and the laser fits both the heater and the optical amplifier. Heat conducted by the heater to the laser when a switch of the heater is turned on matches heat conducted by the optical amplifier to the laser when a switch of the optical amplifier is turned on. For example, a ratio of a value for a drive current of the heater to a value for a drive current of the optical amplifier may be a preset threshold, to ensure that the temperature of the laser remains stable. In an actual application scenario, the optical amplifier may be added to a back end of the laser in the system. The laser works in a fixed current, and controls light output by using the switch of the optical amplifier. When a current is provided for the optical amplifier, light emitted by the laser is amplified by the optical amplifier and then is transmitted. When a negative current or no current is added to the optical amplifier, light emitted by the laser is absorbed inside the optical amplifier, and cannot be transmitted through the optical amplifier.

In this embodiment, the heater and the optical amplifier alternatively work, to ensure that the temperature of the laser does not change, avoiding a wavelength shift.

An embodiment of the present invention further provides a wavelength shift control system. Referring to FIG. 5, an embodiment of the wavelength shift control system in the embodiments of the present invention includes:
Media Access Control MAC 301, a controller 302, and a transmitter 303, where the transmitter 303 includes a laser 3031 and a heater 3032, the laser 3031 fits the heater 3032, and heat conducted by the heater to the laser when a switch of the heater is turned on matches heat of the laser when a switch of the laser is turned off.

The MAC 301 is used to: generate a burst control signal, and send the burst control signal to the controller 302.

The controller 302 is configured to control switch statuses of the laser 3031 and the heater 3032 according to the received burst control signal, where when the switch of the laser 3031 is in an on state, the switch of the heater 3032 is in an off state, and when the switch of the laser 3031 is in an off state, the switch of the heater 3032 is in an on state, so that temperature of the laser 3031 remains stable.

In this embodiment, the burst control signal may be a pulse electrical signal. The pulse electrical signal includes two level statuses (0 and 1). Herein "0" represents a low level, and "1" represents a high level. The two level statuses respectively represent on and off states of the laser 3031.

It should be noted that the heat of the laser 3031 and the heat of the heater 3032 are both related to a drive current of the laser 3031. A larger drive current indicates more heat. The drive current of the laser 3031 is a current required for driving the laser 3031 to work. For a specific laser and a specific heater, a heat conduction relationship between the specific laser and the specific heater is determined. Therefore, as long as it is ensured that the heat conducted by the heater 3032 to the laser 3031 is consistent with the heat of the laser, it can be ensured that the temperature of the laser 3031 remains stable when the switch of the laser 3031 is turned off (the switch of the heater 3032 is turned on) and the switch of the laser 3031 is turned on (the switch of the heater 3032 is turned off). Although heat efficiency of the laser 3031 and heat efficiency of the heater 3032 are different, the heat efficiency is positively related to the drive current, for example, in direct proportion. Specifically, in some optional embodiments, to ensure that the heat of the laser 3031 is consistent with the heat of the heater 3032, it may be ensured that a drive current of the heater 3032 is proportional to the drive current of the laser 3031. To be specific, a ratio of a value for the drive current of the heater 3032 to a value for the drive current of the laser 3031 is a threshold. The threshold herein is determined based on the heat efficiency and heat conduction efficiency of the laser 3031 and the heater 3032, and the threshold is determined for the specific laser 3031 and the specific heater 3032. Specifically, FIG. 6 provides a possible schematic structural diagram of a circuit in which a drive current of a laser 3031 is proportional to a drive current of a heater 3032. In FIG. 6, Media Access Control MAC 301 is used to generate a burst control signal. A controller 302 is configured to provide a drive current. Because the current of the heater 3032 may be inconsistent with the current of the laser 3031, a current divider needs to be added to a link of the heater 3032. The current divider may be a proportional current divider 401 shown in FIG. 6.

In this embodiment, the switch of the laser 3031 and the switch of the heater 3032 are both controlled by using the burst control signal, to implement stable control over temperature of the laser 3031, ensure that a transmit wavelength of the laser 3031 is stable in a burst work process of a transmitter 303 and is not shifted, and avoid impact on normal work of a PON system with a plurality of wavelength paths.

In some embodiments of the present invention, the controller 302 is specifically configured to control, according to a high or low level of the received burst control signal, switch statuses of the laser 3031 and the heater 3032.

When a level of the burst control signal is a high level, the switch of the laser 3031 is in an on state, and when a level of the burst control signal is a low level, the switch of the laser 3031 is in an off state; or
when a level of the burst control signal is a low level, the switch of the laser 3031 is in an off state, and when a level of the burst control signal is a high level, the switch of the laser 3031 is in an on state.

It should be noted that when the switch of the laser 3031 is in the on state, the switch of the heater 3032 is in the off state, and when the switch of the laser 3031 is in the off state, the switch of the heater 3032 is in the on state. Refer to FIG. 3 for a specific schematic diagram of control over the burst control signal. Details are not described herein again.

In this embodiment, the switch of the laser 3031 and the switch of the heater 3032 are both controlled by using the high or low level of the burst control signal, to implement the stable control over the temperature of the laser 3031, ensure that the laser 3031 and the heater 3032 alternately work, ensure that the transmit wavelength of the laser 3031 is stable in the burst work process of the transmitter 303 and is not shifted, and avoid impact on the normal work of the PON system with a plurality of wavelength paths.

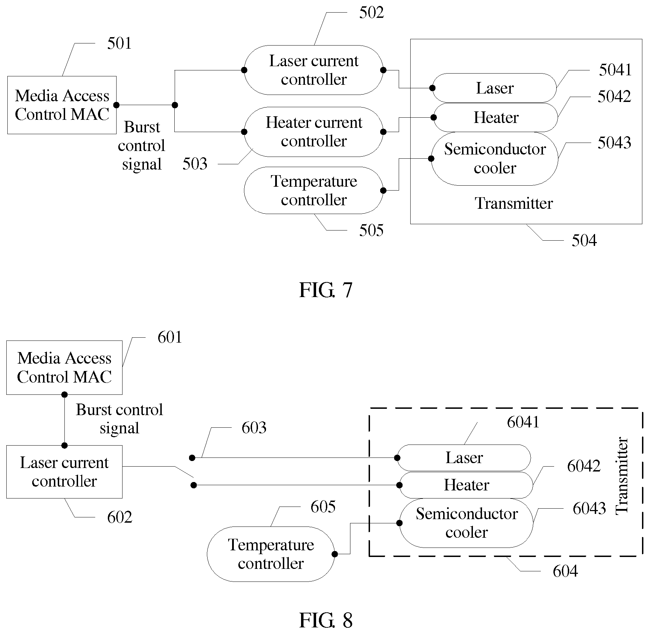

In some embodiments of the present invention, a schematic structural diagram of a possible wavelength shift control system is provided. For details, refer to FIG. 7. Media Access Control 501 generates a burst control signal, and the Media Access Control 501 sends the burst control signal to a laser current controller 502 and a heater current controller 503. The laser current controller 502 turns on a current switch of a laser 5041 in a transmitter 504 according to the received burst control signal, and the heater current controller 503 turns off a current switch of a heater 5042 in the transmitter 504 according to the received burst control signal; or the laser current controller 502 turns off a current switch of a laser 5041 according to the received burst control signal, and the heater current controller 503 turns on a current switch of a heater 5042 according to the received burst control signal. A temperature controller 505 controls a semiconductor cooler 5043 in the transmitter 504, and keeps, by using the semiconductor cooler 5043, overall temperature inside the transmitter 504 unchanged through controlling.

In some embodiments of the present invention, a schematic structural diagram of another possible wavelength shift control system is provided. For details, refer to FIG. 8. Media Access Control 601 generates a burst control signal, and the Media Access Control 601 sends the burst control signal to a laser current controller 602. The laser current controller 602 switches a current switching switch 603 to an input end of a laser 6041 in a transmitter 604 according to the received burst control signal; or the laser current controller 602 switches a current switching switch 603 to an input end of a heater 6042 in the transmitter 604 according to the received burst control signal. A temperature controller 605 controls a semiconductor cooler 6043 in the transmitter 604, and keeps, by using the semiconductor cooler 6043, overall temperature inside the transmitter 604 unchanged through controlling. It should be noted that in some possible implementations, the laser current controller 602 and the current switching switch 603 may be integrated inside a same component, or may be implemented by using different components.

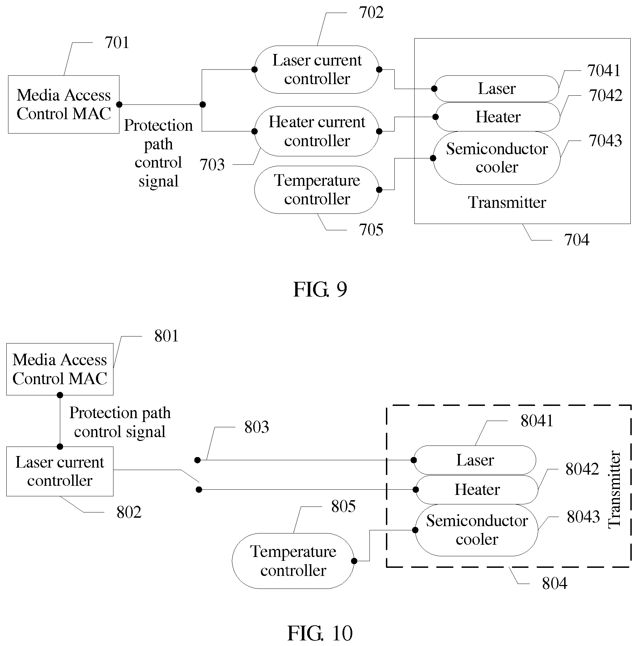

In a PON system, to ensure stable performance of the system, a protection path is usually reserved on an OLT side, and the protection path is relative to a primary path. The controller and the transmitter in the embodiments shown in FIG. 5, FIG. 6, FIG. 7, and FIG. 8 are located in the primary path. Usually, a transmitter of the protection path is turned off. When the PON system detects that the primary path is faulty, the protection path is initiated, and a controller in the protection path receives a protection path control signal output by the MAC. The controller controls switch statuses of the laser and heater in the transmitter according to the protection path control signal, so that temperature of the laser remains stable. In some embodiments of the present invention, a schematic structural diagram of a wavelength shift control system of a protection path is provided. For details, refer to FIG. 9 and FIG. 10. FIG. 9 is a schematic structural diagram similar to FIG. 7. Media Access Control 701 generates a protection path control signal, and the Media Access Control 701 sends the protection path control signal to a laser current controller 702 and a heater current controller 703. The laser current controller 702 turns on a current switch of a laser 7041 in a transmitter 704 according to the received protection path control signal, and the heater current controller 703 turns off a current switch of a heater 7042 in the transmitter 704 according to the received protection path control signal; or the laser current controller 702 turns off a current switch of a laser 7041 according to the received burst control signal, and the heater current controller 703 turns on a current switch of a heater 7042 according to the received burst control signal. A temperature controller 705 controls a semiconductor cooler 7043 in the transmitter 704, and keeps, by using the semiconductor cooler 7043, overall temperature inside the transmitter 704 unchanged through controlling. Likewise, FIG. 10 is a schematic structural diagram similar to FIG. 8. Media Access Control 801 generates a protection path control signal, and the Media Access Control 801 sends the protection path control signal to a laser current controller 802. The laser current controller 802 switches a current switching switch 803 to an input end of a laser 8041 in a transmitter 804 according to the received protection path control signal; or the laser current controller 802 switches a current switching switch 803 to an input end of a heater 8042 in the transmitter 804 according to the received protection path control signal. A temperature controller 805 controls a semiconductor cooler 8043 in the transmitter 804, and keeps, by using the semiconductor cooler 8043, overall temperature inside the transmitter 804 unchanged through controlling. It should be noted that in some possible implementations, the laser current controller 802 and the current switching switch 803 may be integrated inside a same component, or may be implemented by using different components.

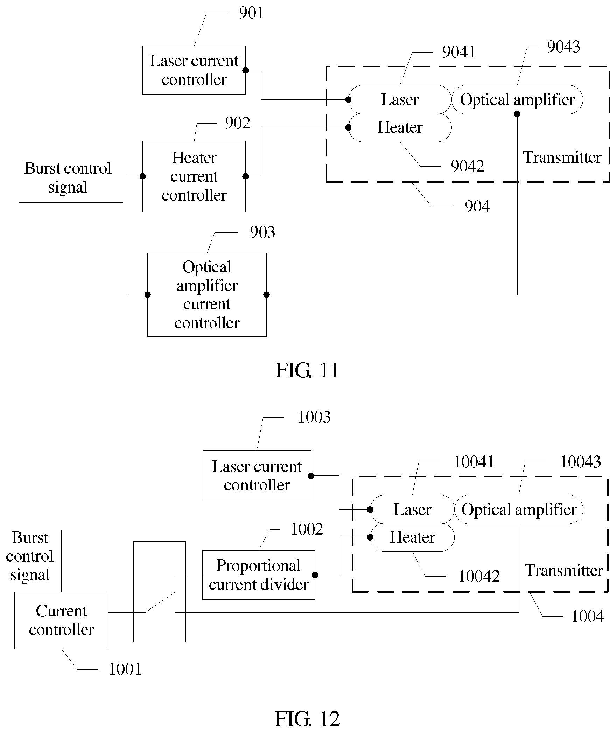

In some embodiments of the present invention, a schematic structural diagram of another possible wavelength shift control system is provided. For details, refer to FIG. 11. A laser current controller 901 provides a fixed current for a laser 9041 in a transmitter 904. A heater current controller 902 and an optical amplifier current controller 903 receive a burst control signal. The heater current controller 902 turns on a switch of a heater 9042 in the transmitter 904 according to the received burst control signal, and the optical amplifier current controller 903 turns off a switch of an optical amplifier 9043 in the transmitter 904 according to the received burst control signal; or the heater current controller 902 turns off a switch of a heater 9042 in the transmitter 904 according to the received burst control signal, and the optical amplifier current controller 903 turns on a switch of an optical amplifier 9043 in the transmitter 904 according to the received burst control signal. The laser 9041 fits both the heater 9042 and the optical amplifier 9043. Heat conducted by the heater 9042 to the laser 9041 when the switch of the heater 9042 is turned on matches heat conducted by the optical amplifier 9043 to the laser 9041 when the switch of the optical amplifier 9043 is turned on. For example, a ratio of a value for a drive current of the heater 9042 to a value for a drive current of the optical amplifier 9043 may be a preset threshold, to ensure that temperature of the laser remains stable. The heater 9042 and the optical amplifier 9043 alternatively work, to ensure that the temperature of the laser 9041 does not change, avoiding a wavelength shift. It should be noted that, to ensure that the temperature of the laser 9041 does not change, the drive current of the heater 9042 should be proportional to the drive current of the optical amplifier 9043, and a specific ratio is determined based on heat efficiency and heat conduction of the heater 9042 and the optical amplifier 9043. Specifically, FIG. 12 provides a schematic structural diagram of a possible circuit in which a drive current of a heater is proportional to a drive current of an optical amplifier. In FIG. 12, a current controller 1001 is configured to provide a drive current. A proportional current divider 1002 is configured to divide a current. A laser current controller 1003 is configured to provide a stable current for a laser 10041 in a transmitter 1004. A heater 10042 and an optical amplifier 10043 in the transmitter both adhere to the laser 10041.

It may be clearly understood by persons skilled in the art that, for the purpose of convenient and brief description, for a detailed working process of the foregoing system, apparatus, and unit, reference may be made to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communications connections may be implemented by using some interfaces. The indirect couplings or communications connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual needs to achieve the objectives of the solutions of the embodiments.

In addition, functional units in the embodiments of the present invention may be integrated into one processing unit, or each of the units may exist alone physically, or two or more units are integrated into one unit. The integrated unit may be implemented in a form of hardware, or may be implemented in a form of a software functional unit.

When the integrated unit is implemented in the form of a software functional unit and sold or used as an independent product, the integrated unit may be stored in a computer-readable storage medium. Based on such an understanding, the technical solutions of the present invention essentially, or the part contributing to the prior art, or all or some of the technical solutions may be implemented in the form of a software product. The software product is stored in a storage medium and includes several instructions for instructing a computer device (which may be a personal computer, a server, or a network device) to perform all or some of the steps of the methods described in the embodiments of the present invention. The foregoing storage medium includes: any medium that can store program code, such as a USB flash drive, a removable hard disk, a read-only memory (ROM, Read-Only Memory), a random access memory (RAM, Random Access Memory), a magnetic disk, or an optical disc. The foregoing embodiments are merely intended for describing the technical solutions of the present invention, but not for limiting the present invention.

## Claims

1. A wavelength shift control method, wherein the method is applied to a wavelength shift control system, the system comprises Media Access Control, MAC, (301, 501), a controller (302), and a transmitter (303), the transmitter (303) comprises a laser (3031) and a heater (3032), the laser (3031) being arranged adjacent to the heater (3032) so as to allow heat transfer from the heater (3032) to the laser (3031), heat conducted by the heater (3032) to the laser (3031) when a switch of the heater (3032) is turned on matches heat of the laser (3031) when a switch of the laser (3031) is turned off, and the method comprises:
generating (101), by the MAC (301), a burst control signal;
sending (102), by the MAC (301), the burst control signal to the controller (302); and
controlling (103), the controller (302), a laser drive switch for the laser (3031) and a heater drive switch for the heater (3032) according to the received burst control signal, wherein when the laser drive switch of the laser (3031) is in an on state, the heater drive switch of the heater (3032) is in an off state, and when the laser drive switch of the laser (3031) is in an off state, the heater drive switch of the heater (3032) is in an on state, so that temperature of the laser (3031) remains stable, and wherein the laser drive switch of the laser (3031) and the heater drive switch of the heater (3032) are both controlled by using the high or low level of the burst control signal to ensure that the laser (3031) and the heater (3032) alternately work, thereby keeping a temperature of the laser (3031) substantially constant during burst operation and thereby controlling a wavelength shift of the laser (3031),
wherein the controller comprises a laser current controller (502) and a heater current controller (503), and the controlling, by the controller, switch statuses of the laser and the heater according to the received burst control signal comprises:
turning on, by the laser current controller (502), a current switch of the laser according to the received burst control signal, and turning off, by the heater current controller (503), a current switch of the heater according to the received burst control signal; or
turning off, by the laser current controller (502), a current switch of the laser according to the received burst control signal, and turning on, by the heater current controller (503), a current switch of the heater according to the received burst control signal.

2. The method according to claim 1, wherein the controlling, by the controller (302), switch statuses of the laser (3031) and the heater (3032) according to the received burst control signal comprises:
controlling, by the controller (302), the switch statuses of the laser (3031) and the heater (3032) according to a high or low level of the received burst control signal, wherein
when a level of the burst control signal is a high level, the switch of the laser (3031) is in the on state, and when a level of the burst control signal is a low level, the switch of the laser (3031) is in the off state; or
when a level of the burst control signal is a low level, the switch of the laser (3031) is in the off state, and when a level of the burst control signal is a high level, the switch of the laser (3031) is in the on state.

3. The method according to claim 1 or 2, wherein the controller (302) is a controller (302) in a primary path of the system, the transmitter (303) is a transmitter (303) in the primary path of the system, and the method further comprises:
after the primary path is faulty, generating, by the MAC (301), a protection path control signal;
sending, by the MAC (301), the protection path control signal to a controller (302) in a preset protection path; and
controlling, by the controller (302) in the protection path, switch statuses of a laser (3031) and a heater (3032) in the protection path according to the received protection path control signal, wherein when a switch of the laser (3031) in the protection path is in an on state, the heater (3032) in the protection path is in an off state, and when a switch of the laser (3031) in the protection path is in an off state, the heater (3032) in the protection path is in an on state, so that temperature of the laser (3031) in the protection path remains stable.

4. The method according to any one of claims 1 to 3, wherein the controller (302) provides a drive current of the heater (3032) and a drive current of the laser (3031).

5. The method according to any one of claims 1 to 4, wherein a ratio of a value for the drive current of the heater (3032) to a value for the drive current of the laser (3031) is a preset threshold.

6. A wavelength shift control method, wherein the method is applied to a wavelength shift control system, the system comprises Media Access Control MAC, a controller, and a transmitter, the transmitter comprises a laser, a heater, and an optical amplifier, the laser being arranged adjacent to the heater and the optical amplifier so as to allow heat transfer to the laser, heat conducted by the heater to the laser when a heater drive switch of the heater is turned on matches heat conducted by the optical amplifier to the laser when a drive switch of the optical amplifier is turned on, and the method comprises
generating (201), by the MAC, a burst control signal;
sending (202), by the MAC, the burst control signal to the controller (302); and
controlling, by the controller, heater drive switch for the heater and a drive switch for the optical amplifier according to the received burst control signal, wherein when the heater drive switch of the heater is in an on state, the drive switch of the optical amplifier is in an off state, and when the heater drive switch of the heater is in an off state, the drive switch of the optical amplifier is in an on state, so that temperature of the laser remains stable, and wherein the optical amplifier drive switch (9043) and the heater drive switch of the heater (9042) are both controlled by using the high or low level of the burst control signal to ensure that the optical amplifier (9043) and the heater (9042) alternately work, thereby keeping the temperature of the laser substantially constant and thereby controlling a wavelength shift of the laser.

7. The method according to claim 6, wherein the controller provides a drive current of the heater and a drive current of the optical amplifier.

8. The method according to claim 6 or 7, wherein a ratio of a value for the drive current of the heater to a value for the drive current of the optical amplifier is a preset threshold.

9. A wavelength shift control system, comprising:
Media Access Control, MAC, (301, 501), a controller (302), and a transmitter (303), wherein the transmitter (303) comprises a laser (3031) and a heater (3032), the laser (3031) being arranged adjacent to the heater (3032) so as to allow heat transfer from the heater (3032) to the laser (3031), and heat conducted by the heater (3032) to the laser (3031) when a switch of the heater (3032) is turned on matches heat of the laser (3031) when a switch of the laser (3031) is turned off;
the MAC (301) is configured to: generate a burst control signal, and send the burst control signal to the controller (302); and
the controller (302) is configured to control a laser drive switch for the laser (3031) and a heater drive switch for the heater (3032) according to the received burst control signal, wherein when the laser drive switch of the laser (3031) is in an on state, the heater drive switch of the heater (3032) is in an off state, and when the laser drive switch of the laser (3031) is in an off state, the heater drive switch of the heater (3032) is in an on state, so that temperature of the laser (3031) remains stable, and wherein the laser drive switch of the laser (3031) and the heater drive switch of the heater (3032) are both controlled by using the high or low level of the burst control signal to ensure that the laser and the heater alternately work, thereby keeping a temperature of the laser (3031) substantially constant and thereby controlling a wavelength shift of the laser (3031),
wherein the controller comprises a laser current controller and a heater current controller, the laser current controller is configured to turn on a current switch of the laser according to the received burst control signal, and the heater current controller is configured to turn off a current switch of the heater according to the received burst control signal; or the laser current controller is configured to turn off a current switch of the laser according to the received burst control signal, and the heater current controller is configured to turn on a current switch of the heater according to the received burst control signal.

10. The system according to claim 9, wherein the controller is specifically configured to control the switch statuses of the laser and the heater according to a high or low level of the received burst control signal, wherein
when a level of the burst control signal is a high level, the switch of the laser is in the on state, and when a level of the burst control signal is a low level, the switch of the laser is in the off state; or
when a level of the burst control signal is a low level, the switch of the laser is in the off state, and when a level of the burst control signal is a high level, the switch of the laser is in the on state.

11. The system according to claim 9 or 10, wherein the controller is a controller in a primary path of the system, the transmitter is a transmitter in the primary path of the system, the MAC is further configured to: after the primary path is faulty, generate a protection path control signal, and send the protection path control signal to a controller in a preset protection path, the system further comprises the controller in the protection path, and the controller in the protection path is configured to control switch statuses of a laser and a heater in the protection path according to the received protection path control signal, wherein when a switch of the laser in the protection path is in an on state, the heater in the protection path is in an off state, and when a switch of the laser in the protection path is in an off state, the heater in the protection path is in an on state, so that temperature of the laser in the protection path remains stable.

12. The system according to any one of claims 9 to 11, wherein the controller provides a drive current of the heater and a drive current of the laser.

13. The system according to any one of claims 9 to 12, wherein a ratio of a value for the drive current of the heater to a value for the drive current of the laser is a preset threshold.

14. A wavelength shift control system, comprising:
Media Access Control, MAC, a controller, and a transmitter, wherein the transmitter comprises a laser, a heater, and an optical amplifier, the laser being arranged adjacent to the heater and the optical amplifier so as to allow heat transfer to the laser, and heat conducted by the heater to the laser when a heater drive switch of the heater is turned on matches heat conducted by the optical amplifier to the laser when a drive switch of the optical amplifier is turned on;
the MAC is configured to: generate a burst control signal, and send the burst control signal to the controller; and
the controller is configured to control a heater drive switch for the heater and a drive switch for the optical amplifier according to the received burst control signal, wherein when the heater drive switch of the heater is in an on state, the drive switch of the optical amplifier is in an off state, and when the heater drive switch of the heater is in an off state, the drive switch of the optical amplifier is in an on state, so that temperature of the laser remains stable, and wherein the drive switch of the optical amplifier (9043) and the heater drive switch of the heater (9042) are both controlled by using the high or low level of the burst control signal to ensure that the optical amplifier (9043) and the heater (9042) alternately work, thereby keeping the temperature of the laser substantially constant and thereby controlling a wavelength shift of the laser.

15. The system according to claim 14, wherein the controller (302) provides a drive current of the heater (3032) and a drive current of the optical amplifier (9043).

16. The system according to claim 14 or 15, wherein a ratio of a value for the drive current of the heater (3032) to a value for the drive current of the optical amplifier (9043) is a preset threshold.

## Patentansprüche

1. Verfahren zum Steuern einer Wellenlängenverschiebung, wobei das Verfahren auf ein System zum Steuern einer Wellenlängenverschiebung angewandt wird, wobei das System eine Medienzugriffssteuerung, Media Access Control, MAC, (301, 501), eine Steuerung (302) und einen Sender (303) umfasst, der Sender (303) einen Laser (3031) und eine Heizung (3032) umfasst, wobei der Laser (3031) derart an die Heizung (3032) angrenzend angeordnet ist, dass eine Wärmeübertragung von der Heizung (3032) zu dem Laser (3031) ermöglicht wird, Wärme, die von der Heizung (3032) zu dem Laser (3031) geleitet wird, wenn ein Schalter der Heizung (3032) angeschaltet ist, mit der Wärme des Lasers (3031) übereinstimmt, wenn ein Schalter des Lasers (3031) ausgeschaltet ist, und das Verfahren Folgendes umfasst:
Erzeugen (101), durch die MAC (301), eines "Burst"-Steuersignals;
Senden (102), durch die MAC (301), des "Burst"-Steuersignals an die Steuerung (302); und
Steuern (103), durch die Steuerung (302), eines Laseransteuerungsschalters für den Laser (3031) und eines Heizungsansteuerungsschalters für die Heizung (3032) gemäß dem empfangenen "Burst"-Steuersignal, wobei, wenn sich der Laseransteuerungsschalter des Lasers (3031) in einem angeschalteten Zustand befindet, sich der Heizungsansteuerungsschalter der Heizung (3032) in einem ausgeschalteten Zustand befindet, und wenn sich der Laseransteuerungsschalter des Lasers (3031) in einem ausgeschalteten Zustand befindet, sich der Heizungsansteuerungsschalter der Heizung (3032) in einem angeschalteten Zustand befindet, so dass die Temperatur des Lasers (3031) stabil bleibt, und wobei sowohl der Laseransteuerungsschalter des Lasers (3031) als auch der Heizungsansteuerungsschalter der Heizung (3032) mit Hilfe des hohen oder niedrigen Pegels des "Burst"-Steuersignals gesteuert werden, um sicherzustellen, dass der Laser (3031) und die Heizung (3032) abwechselnd arbeiten, wodurch eine Temperatur des Lasers (3031) während des "Burst"-Betriebes im Wesentlichen konstant gehalten wird und dadurch eine Wellenlängenverschiebung des Lasers (3031) gesteuert wird,
wobei die Steuerung eine Laserstromsteuerung (502) und eine Heizungsstromsteuerung (503) umfasst und das Steuern, durch die Steuerung, von Schalterzuständen des Lasers und der Heizung gemäß dem empfangenen "Burst"-Steuersignal Folgendes umfasst:
Anschalten, durch die Laserstromsteuerung (502), eines Stromschalters des Lasers gemäß dem empfangenen "Burst"-Steuersignal und Ausschalten, durch die Heizungsstromsteuerung (503), eines Stromschalters der Heizung gemäß dem empfangenen "Burst"-Steuersignal; oder
Ausschalten, durch die Laserstromsteuerung (502), eines Stromschalters des Lasers gemäß dem empfangenen "Burst"-Steuersignal und Anschalten, durch die Heizungsstromsteuerung (503), eines Stromschalters der Heizung gemäß dem empfangenen "Burst"-Steuersignal.

2. Verfahren nach Anspruch 1, wobei das Steuern, durch die Steuerung (302), der Schalterzustände des Lasers (3031) und der Heizung (3032) gemäß dem empfangenen "Burst"-Steuersignal Folgendes umfasst:
Steuern, durch die Steuerung (302), der Schalterzustände des Lasers (3031) und der Heizung (3032) gemäß einem hohen oder einem niedrigen Pegel des empfangenen "Burst"-Steuersignals, wobei:
wenn ein Pegel des "Burst"-Steuersignals ein hoher Pegel ist, sich der Schalter des Lasers (3031) in dem angeschalteten Zustand befindet, und wenn ein Pegel des "Burst"-Steuersignals ein niedriger Pegel ist, sich der Schalter des Lasers (3031) in dem ausgeschalteten Zustand befindet; oder
wenn ein Pegel des "Burst"-Steuersignals ein niedriger Pegel ist, sich der Schalter des Lasers (3031) in dem ausgeschalteten Zustand befindet, und wenn ein Pegel des "Burst"-Steuersignals ein hoher Pegel ist, sich der Schalter des Lasers (3031) in dem angeschalteten Zustand befindet.

3. Verfahren nach Anspruch 1 oder 2, wobei die Steuerung (302) eine Steuerung (302) in einem primären Weg des Systems ist, der Sender (303) ein Sender (303) in dem primären Weg des Systems ist und das Verfahren ferner Folgendes umfasst:
nachdem der primäre Weg ausgefallen ist, Erzeugen, durch die MAC (301), eines Schutzweg-Steuersignals;
Senden, durch die MAC (301), des Schutzweg-Steuersignals an eine Steuerung (302) in einem voreingestellten Schutzweg; und
Steuern, durch die Steuerung (302) in dem Schutzweg, von Schaltzuständen eines Lasers (3031) und einer Heizung (3032) in dem Schutzpfad gemäß dem empfangenen Schutzweg-Steuersignal, wobei, wenn sich ein Schalter des Lasers (3031) in dem Schutzweg in einem angeschalteten Zustand befindet, sich die Heizung (3032) in dem Schutzweg in einem ausgeschalteten Zustand befindet, und wenn sich ein Schalter des Lasers (3031) in dem Schutzweg in einem ausgeschalteten Zustand befindet, sich die Heizung (3032) in dem Schutzweg in einem angeschalteten Zustand befindet, so dass die Temperatur des Lasers (3031) in dem Schutzweg stabil bleibt.

4. Verfahren nach einem der Ansprüche 1 bis 3, wobei die Steuerung (302) einen Ansteuerungsstrom der Heizung (3032) und einen Ansteuerungsstrom des Lasers (3031) bereitstellt.

5. Verfahren nach einem der Ansprüche 1 bis 4, wobei ein Verhältnis eines Wertes für den Ansteuerungsstrom der Heizung (3032) zu einem Wert für den Ansteuerungsstrom des Lasers (3031) ein voreingestellter Schwellenwert ist.

6. Verfahren zum Steuern einer Wellenlängenverschiebung, wobei das Verfahren auf ein System zum Steuern einer Wellenlängenverschiebung angewandt wird, wobei das System eine Medienzugriffssteuerung, Media Access Control, MAC, eine Steuerung und einen Sender umfasst, der Sender einen Laser, eine Heizung und einen optischen Verstärker umfasst, wobei der Laser an die Heizung und den optischen Verstärker angrenzend angeordnet ist, so dass eine Wärmeübertragung an den Laser ermöglicht ist, Wärme, die von der Heizung zu dem Laser geleitet wird, wenn ein Heizungsansteuerungsschalter der Heizung angeschaltet ist, mit Wärme übereinstimmt, die durch den optischen Verstärker zu dem Laser geleitet wird, wenn ein Ansteuerungsschalter des optischen Verstärkers angeschaltet ist, und das Verfahren Folgendes umfasst:
Erzeugen (201), durch die MAC, eines "Burst"-Steuersignals;
Senden (202), durch die MAC, des "Burst"-Steuersignals an die Steuerung (302); und
Steuern, durch die Steuerung, eines Heizungsansteuerungsschalters für die Heizung und eines Ansteuerungsschalters für den optischen Verstärker gemäß dem empfangenen "Burst"-Steuersignal, wobei, wenn sich der Heizungsansteuerungsschalter der Heizung in einem angeschalteten Zustand befindet, sich der Ansteuerungsschalter des optischen Verstärkers in einem ausgeschalteten Zustand befindet, und wenn sich der Heizungsansteuerungsschalter der Heizung in einem ausgeschalteten Zustand befindet, sich der Ansteuerungsschalter des optischen Verstärkers in einem angeschalteten Zustand befindet, so dass die Temperatur des Lasers stabil bleibt, und wobei sowohl der Ansteuerungsschalter (9043) des optischen Verstärkers als auch der Heizungsansteuerungsschalter der Heizung (9042) mit Hilfe des hohen oder niedrigen Pegels des "Burst"-Steuersignals gesteuert werden, um sicherzustellen, dass der optische Verstärker (9043) und die Heizung (9042) abwechselnd arbeiten, wodurch die Temperatur des Lasers im Wesentlichen konstant gehalten wird und dadurch eine Wellenlängenverschiebung des Lasers gesteuert wird.

7. Verfahren nach Anspruch 6, wobei die Steuerung einen Ansteuerungsstrom der Heizung und einen Ansteuerungsstrom des optischen Verstärkers bereitstellt.

8. Verfahren nach Anspruch 6 oder 7, wobei ein Verhältnis eines Wertes für den Ansteuerungsstrom der Heizung zu einem Wert für den Ansteuerungsstrom des optischen Verstärkers ein voreingestellter Schwellenwert ist.

9. System zum Steuern einer Wellenlängenverschiebung, Folgendes umfassend:
eine Medienzugriffssteuerung, Media Access Control, MAC, (301, 501),
eine Steuerung (302) und einen Sender (303), wobei der Sender (303) einen Laser (3031) und eine Heizung (3032) umfasst, wobei der Laser (3031) derart an die Heizung (3032) angrenzend angeordnet ist, dass eine Wärmeübertragung von der Heizung (3032) zu dem Laser (3031) ermöglicht ist, und Wärme, die von der Heizung (3032) zu dem Laser (3031) geleitet wird, wenn ein Schalter der Heizung (3032) angeschaltet ist, mit der Wärme des Lasers (3031) übereinstimmt, wenn ein Schalter des Lasers (3031) ausgeschaltet ist;
wobei die MAC (301) für Folgendes konfiguriert ist: Erzeugen eines "Burst"-Steuersignals und Senden des "Burst"-Steuersignals an die Steuerung (302); und
die Steuerung (302) dafür konfiguriert ist, einen Laseransteuerungsschalter für den Laser (3031) und einen Heizungsansteuerungsschalter für die Heizung (3032) gemäß dem empfangenen "Burst"-Steuersignal zu steuern, wobei, wenn sich der Laseransteuerungsschalter des Lasers (3031) in einem angeschalteten Zustand befindet, sich der Heizungsansteuerungsschalter der Heizung (3032) in einem ausgeschalteten Zustand befindet, und wenn sich der Laseransteuerungsschalter des Lasers (3031) in einem ausgeschalteten Zustand befindet, sich der Heizungsansteuerungsschalter der Heizung (3032) in einem angeschalteten Zustand befindet, so dass die Temperatur des Lasers (3031) stabil bleibt, und wobei sowohl der Laseransteuerungsschalter des Lasers (3031) als auch der Heizungsansteuerungsschalter der Heizung (3032) mit Hilfe des hohen oder niedrigen Pegels des "Burst"-Steuersignals gesteuert werden, um sicherzustellen, dass der Laser und die Heizung abwechselnd arbeiten, wodurch eine Temperatur des Lasers (3031) im Wesentlichen konstant gehalten wird und dadurch eine Wellenlängenverschiebung des Lasers (3031) gesteuert wird,
wobei die Steuerung eine Laserstromsteuerung und eine Heizungsstromsteuerung umfasst, die Laserstromsteuerung dafür konfiguriert ist, einen Stromschalter des Lasers gemäß dem empfangenen "Burst"-Steuersignal anzuschalten, und die Heizungsstromsteuerung dafür konfiguriert ist, einen Stromschalter der Heizung gemäß dem empfangenen "Burst"-Steuersignal auszuschalten; oder die Laserstromsteuerung dafür konfiguriert ist, einen Stromschalter des Lasers gemäß dem empfangenen "Burst"-Steuersignal auszuschalten, und die Heizungsstromsteuerung dafür konfiguriert ist, einen Stromschalter der Heizung gemäß dem empfangenen "Burst"-Steuersignal anzuschalten.

10. System nach Anspruch 9, wobei die Steuerung speziell dafür konfiguriert ist, die Schaltzustände des Lasers und der Heizung gemäß einem hohen oder einem niedrigen Pegel des empfangenen "Burst"-Steuersignals zu steuern, wobei
wenn ein Pegel des "Burst"-Steuersignals ein hoher Pegel ist, sich der Schalter des Lasers in dem angeschalteten Zustand befindet, und wenn ein Pegel des "Burst"-Steuersignals ein niedriger Pegel ist, sich der Schalter des Lasers in dem ausgeschalteten Zustand befindet; oder
wenn ein Pegel des "Burst"-Steuersignals ein niedriger Pegel ist, sich der Schalter des Lasers in dem ausgeschalteten Zustand befindet, und wenn ein Pegel des "Burst"-Steuersignals ein hoher Pegel ist, sich der Schalter des Lasers in dem angeschalteten Zustand befindet.

11. System nach Anspruch 9 oder 10, wobei die Steuerung eine Steuerung in einem primären Weg des Systems ist, der Sender ein Sender in dem primären Weg des Systems ist, wobei die MAC ferner für Folgendes konfiguriert ist: nachdem der primäre Weg ausgefallen ist, Erzeugen eines Schutzweg-Steuersignals und Senden des Schutzweg-Steuersignals an eine Steuerung in einem voreingestellten Schutzweg, das System ferner die Steuerung in dem Schutzweg umfasst und die Steuerung in dem Schutzweg dafür konfiguriert ist, Schaltzustände eines Lasers und einer Heizung in dem Schutzweg gemäß dem empfangenen Schutzweg-Steuersignal zu steuern, wobei, wenn sich ein Schalter des Lasers in dem Schutzweg in einem angeschalteten Zustand befindet, sich die Heizung in dem Schutzweg in einem ausgeschalteten Zustand befindet, und wenn sich ein Schalter des Lasers in dem Schutzweg in einem ausgeschalteten Zustand befindet, sich die Heizung in dem Schutzweg in einem angeschalteten Zustand befindet, so dass die Temperatur des Lasers in dem Schutzweg stabil bleibt.

12. System nach einem der Ansprüche 9 bis 11, wobei die Steuerung einen Ansteuerungsstrom der Heizung und einen Ansteuerungsstrom des Lasers bereitstellt.

13. System nach einem der Ansprüche 9 bis 12, wobei ein Verhältnis eines Wertes für den Ansteuerungsstrom der Heizung zu einem Wert für den Ansteuerungsstrom des Lasers ein voreingestellter Schwellenwert ist.

14. System zum Steuern einer Wellenlängenverschiebung, Folgendes umfassend:
eine Medienzugriffssteuerung, Media Access Control, MAC,
eine Steuerung und einen Sender, wobei der Sender einen Laser, eine Heizung und einen optischen Verstärker umfasst, wobei der Laser an die Heizung und den optischen Verstärker angrenzend angeordnet ist, so dass eine Wärmeübertragung an den Laser ermöglicht ist, und Wärme, die von der Heizung zu dem Laser geleitet wird, wenn ein Heizungsansteuerungsschalter der Heizung angeschaltet ist, mit der Wärme übereinstimmt, die durch den optischen Verstärker zu dem Laser geleitet wird, wenn ein Ansteuerungsschalter des optischen Verstärkers angeschaltet ist,
wobei die MAC für Folgendes konfiguriert ist: Erzeugen eines "Burst"-Steuersignals und Senden des "Burst"-Steuersignals an die Steuerung; und
die Steuerung dafür konfiguriert ist, einen Heizungsansteuerungsschalter für die Heizung und einen Ansteuerungsschalter für den optischen Verstärker gemäß dem empfangenen "Burst"-Steuersignal zu steuern, wobei, wenn sich der Heizungsansteuerungsschalter der Heizung in einem angeschalteten Zustand befindet, sich der Ansteuerungsschalter des optischen Verstärkers in einem ausgeschalteten Zustand befindet, und wenn sich der Heizungsansteuerungsschalter der Heizung in einem ausgeschalteten Zustand befindet, sich der Ansteuerungsschalter des optischen Verstärkers in einem angeschalteten Zustand befindet, so dass die Temperatur des Lasers stabil bleibt, und wobei sowohl der Ansteuerungsschalter des optischen Verstärkers (9043) als auch der Heizungsansteuerungsschalter der Heizung (9042) mit Hilfe des hohen oder niedrigen Pegels des "Burst"-Steuersignals gesteuert werden, um sicherzustellen, dass der optische Verstärker (9043) und die Heizung (9042) abwechselnd arbeiten, wodurch die Temperatur des Lasers im Wesentlichen konstant gehalten wird und dadurch eine Wellenlängenverschiebung des Lasers gesteuert wird.

15. System nach Anspruch 14, wobei die Steuerung (302) einen Ansteuerungsstrom der Heizung (3032) und einen Ansteuerungsstrom des optischen Verstärkers (9043) bereitstellt.

16. System nach Anspruch 14 oder 15, wobei ein Verhältnis eines Wertes für den Ansteuerungsstrom der Heizung (3032) zu einem Wert für den Ansteuerungsstrom des optischen Verstärkers (9043) ein voreingestellter Schwellenwert ist.

## Revendications

1. Procédé de contrôle de décalage de longueur d'onde, ce procédé étant appliqué à un système de contrôle de décalage de longueur d'onde, ce système comportant une commande d'accès au support, MAC, (301, 501), un dispositif de commande (302), et un transmetteur (303), ce transmetteur (303) comportant un laser (3031) et un élément chauffant (3032), ce laser (3031) étant disposé adjacent à l'élément chauffant (3032) afin de permettre le transfert de chaleur de l'élément chauffant (3032) au laser (3031), la chaleur conduite par l'élément chauffant (3032) jusqu'au laser (3031) lorsqu'un commutateur de l'élément chauffant (3032) est mis sous tension correspondant à la chaleur du laser (3031) lorsqu'un commutateur du laser (3031) est mis hors tension, et ce procédé comprenant :
la génération (101), par la MAC (301), d'un signal de commande par salves ;
l'envoi (102), par la MAC (301), de ce signal de commande par salves au dispositif de commande (302) ; et
la commande (103), par le dispositif de commande (302), d'un commutateur de commande de laser pour le laser (3031) et d'un commutateur de commande d'élément chauffant pour l'élément chauffant (3032) en fonction du signal de commande par salves reçu, commande dans laquelle, lorsque le commutateur de commande de laser du laser (3031) est dans un état sous tension, le commutateur de commande d'élément chauffant de l'élément chauffant (3032) est dans un état hors tension, et lorsque le commutateur de commande de laser du laser (3031) est dans un état hors tension, le commutateur de commande d'élément chauffant de l'élément chauffant (3032) est dans un état sous tension, de façon à ce que la température du laser (3031) reste stable, et dans laquelle le commutateur de commande de laser du laser (3031) et le commutateur de commande d'élément chauffant de l'élément chauffant (3032) sont tous les deux commandés en utilisant le haut niveau ou le bas niveau du signal de commande par salves de façon à ce que le laser (3031) et l'élément chauffant (3032) fonctionnent tour à tour, maintenant ainsi une température du laser (3031) essentiellement constante pendant le fonctionnement par salves, et contrôlant ainsi un décalage de longueur d'onde du laser (3031),
le dispositif de commande comprenant un dispositif de commande du courant du laser (502) et un dispositif de commande du courant de l'élément chauffant (3032), et la commande, par le dispositif de commande, des états des commutateurs du laser et de l'élément chauffant en fonction du signal de commande par salves reçu comprenant :
la mise sous tension, par le dispositif de commande du courant du laser (502), d'un commutateur du courant du laser en fonction du signal de commande par salves reçu, et la mise hors tension, par le dispositif de commande du courant de l'élément chauffant (503), d'un commutateur du courant de l'élément chauffant en fonction du signal de commande par salves reçu ; ou
la mise hors tension, par le dispositif de commande du courant du laser (502), d'un commutateur du courant du laser en fonction du signal de commande par salves reçu, et la mise sous tension, par le dispositif de commande du courant de l'élément chauffant (503), d'un commutateur du courant de l'élément chauffant en fonction du signal de commande par salves reçu.

2. Procédé selon la revendication 1, dans lequel la commande, par le dispositif de commande (302), des états des commutateurs du laser (3031) et de l'élément chauffant (3032) en fonction du signal de commande par salves reçu comprend :
la commande, par le dispositif de commande (302), des états des commutateurs du laser (3031) et de l'élément chauffant (3032) en fonction d'un haut niveau ou d'un bas niveau du signal de commande par salves reçu, commande dans laquelle
lorsqu'un niveau du signal de commande par salves est un haut niveau, le commutateur du laser (3031) est dans l'état sous tension, et, lorsqu'un niveau du signal de commande par salves est un bas niveau, le commutateur du laser (3031) est dans l'état hors tension ; ou
lorsqu'un niveau du signal de commande par salves est un bas niveau, le commutateur du laser (3031) est dans l'état hors tension, et lorsqu'un niveau du signal de commande par salves est un haut niveau, le commutateur du laser (3031) est dans l'état sous tension.

3. Procédé selon la revendication 1 ou 2, dans lequel le dispositif de commande (302) est un dispositif de commande (302) dans un chemin primaire du système, le transmetteur (303) est un transmetteur (303) dans le chemin primaire du système, et ce procédé comprenant en outre :
une fois que le chemin primaire est défectueux, la génération, par la MAC (301), d'un signal de commande de chemin de protection ;
l'envoi, par la MAC (301), de ce signal de commande de chemin de protection à un dispositif de commande (302) dans un chemin de protection prédéterminé ; et
la commande, par le dispositif de commande (302) dans le chemin de protection, des états des commutateurs d'un laser (3031) et d'un élément chauffant (3032) dans le chemin de protection en fonction du signal de commande de chemin de protection reçu, commande dans laquelle, lorsqu'un commutateur du laser (3031) dans le chemin de protection est dans un état sous tension, l'élément chauffant (3032) dans le chemin de protection est dans un état hors tension, et lorsqu'un commutateur du laser (3031) dans le chemin de protection est dans un état hors tension, l'élément chauffant (3032) dans le chemin de protection est dans un état sous tension, de façon à ce que la température du laser (3031) dans le chemin de protection reste stable.

4. Procédé selon l'une quelconque des revendications 1 à 3, dans lequel le dispositif de commande (302) fournit un courant de commande de l'élément chauffant (3032) et un courant de commande du laser (3031).

5. Procédé selon l'une quelconque des revendications 1 à 4, dans lequel un rapport entre une valeur pour le courant de commande de l'élément chauffant (3032) et une valeur pour le courant de commande du laser (3031) est un seuil prédéterminé.

6. Procédé de contrôle de décalage de longueur d'onde, ce procédé étant appliqué à un système de contrôle de décalage de longueur d'onde, ce système comportant une commande d'accès au support, MAC, un dispositif de commande et un transmetteur, ce transmetteur comportant un laser, un élément chauffant et un amplificateur optique, ce laser étant disposé adjacent à l'élément chauffant et à l'amplificateur optique afin de permettre le transfert de chaleur au laser, la chaleur conduite par l'élément chauffant jusqu'au laser lorsqu'un commutateur de commande d'élément chauffant de l'élément chauffant est mis sous tension correspondant à la chaleur conduite par l'amplificateur optique jusqu'au laser lorsqu'un commutateur de commande de l'amplificateur optique est mis sous tension, et ce procédé comprenant :
la génération (201), par la MAC, d'un signal de commande par salves ;
l'envoi (202), par la MAC, de ce signal de commande par salves au dispositif de commande (302) ; et
la commande, par le dispositif de commande, d'un commutateur de commande d'élément chauffant pour l'élément chauffant et d'un commutateur de commande pour l'amplificateur optique en fonction du signal de commande par salves reçu, commande dans laquelle, lorsque le commutateur de commande d'élément chauffant de l'élément chauffant est dans un état sous tension, le commutateur de commande de l'amplificateur optique est dans un état hors tension, et, lorsque le commutateur de commande d'élément chauffant de l'élément chauffant est dans un état hors tension, le commutateur de commande de l'amplificateur optique est dans un état sous tension, de façon à ce que la température du laser reste stable, et dans laquelle le commutateur de commande de l'amplificateur optique (9043) et le commutateur de commande d'élément chauffant de l'élément chauffant (9042) sont tous les deux commandés en utilisant le haut niveau ou le bas niveau du signal de commande par salves pour faire en sorte que l'amplificateur optique (9543) et l'élément chauffant (9042) fonctionnent tour à tour, maintenant ainsi la température du laser essentiellement constante, et contrôlant ainsi un décalage de longueur d'onde du laser.

7. Procédé selon la revendication 6, dans lequel le dispositif de commande fournit un courant de commande de l'élément chauffant et un courant de commande de l'amplificateur optique.

8. Procédé selon la revendication 6 ou 7, dans lequel un rapport entre une valeur pour le courant de commande de l'élément chauffant et une valeur pour le courant de commande de l'amplificateur optique est un seuil prédéterminé.

9. Système de contrôle de décalage de longueur d'onde, comprenant :
une commande d'accès au support, MAC, (301, 501),
un dispositif de commande (302) et
un transmetteur (303), ce transmetteur (303) comprenant un laser (3031) et un élément chauffant (3032), le laser (3031) étant disposé adjacent à l'élément chauffant (3032) afin de permettre le transfert de chaleur de l'élément chauffant (3032) au laser (3031), et la chaleur conduite par l'élément chauffant (3032) au laser (3031) lorsqu'un commutateur de l'élément chauffant (3032) est mis sous tension correspondant à la chaleur du laser (3031) lorsqu'un commutateur du laser (3031) est mis hors tension ;
la MAC (301) étant configurée de façon à : générer un signal de commande par salves et envoyer ce signal de commande par salves au dispositif de commande (302) ; et
le dispositif de commande (302) étant configuré de façon à commander un commutateur de commande de laser pour le laser (3031) et un commutateur de commande d'élément chauffant pour l'élément chauffant (3032) en fonction du signal de commande par salves reçu, commande dans laquelle, lorsque le commutateur de commande de laser du laser (3031) est dans un état sous tension, le commutateur de commande d'élément chauffant de l'élément chauffant (3032) est dans un état hors tension, et lorsque le commutateur de commande de laser du laser (3031) est dans un état hors tension, le commutateur de commande d'élément chauffant de l'élément chauffant (3032) est dans un état hors tension, de façon à ce que la température du laser (3031) reste stable, et dans laquelle le commutateur de commande de laser du laser (3031) et le commutateur de commande d'élément chauffant de l'élément chauffant (3032) sont tous les deux commandés en utilisant le haut niveau ou le bas niveau du signal de commande par salves pour faire en sorte que le laser et l'élément chauffant fonctionnent tour à tour, maintenant ainsi une température du laser (3031) essentiellement constante et contrôlant ainsi un décalage de longueur d'onde du laser (3031),
le dispositif de commande comprenant un dispositif de commande du courant du laser et un dispositif de commande du courant de l'élément chauffant, le dispositif de commande du courant du laser étant configuré de façon à mettre sous tension un commutateur du courant du laser en fonction du signal de commande par salves reçu, et le dispositif de commande du courant de l'élément chauffant étant configuré de façon à mettre hors tension un commutateur du courant de l'élément chauffant en fonction du signal de commande par salves reçu ; ou le dispositif de commande du courant du laser étant configuré de façon à mettre hors tension un commutateur du courant du laser en fonction du signal de commande par salves reçu, et le dispositif de commande du courant de l'élément chauffant étant configuré de façon à mettre sous tension un commutateur du courant de l'élément chauffant en fonction du signal de commande par salves reçu.

10. Système selon la revendication 9, dans lequel le dispositif de commande est configuré spécifiquement de façon à commander les états des commutateurs du laser et de l'élément chauffant en fonction d'un haut niveau ou d'un bas niveau du signal de commande par salves reçu, dans lequel
lorsqu'un niveau du signal de commande par salves est un haut niveau, le commutateur du laser est dans l'état sous tension, et lorsqu'un niveau du signal de commande par salves est un bas niveau, le commutateur du laser est dans l'état hors tension ; ou
lorsqu'un niveau du signal de commande par salves est un bas niveau, le commutateur du laser est dans l'état hors tension, et, lorsqu'un niveau du signal de commande par salves est un haut niveau, le commutateur du laser est dans l'état sous tension.

11. Système selon la revendication 9 ou 10, dans lequel le dispositif de commande est un dispositif de commande dans un chemin primaire de ce système, le transmetteur est un transmetteur dans le chemin primaire de ce système, la MAC est configurée en outre de façon à : une fois que le chemin primaire est défectueux, générer un signal de commande de chemin de protection, et envoyer ce signal de commande de chemin de protection à un dispositif de commande dans un chemin de protection prédéterminé, ce système comprenant en outre le dispositif de commande dans le chemin de protection, et le dispositif de commande dans le chemin de protection étant configuré de façon à commander les états des commutateurs d'un laser et d'un élément chauffant dans le chemin de protection en fonction du signal de commande de chemin de protection reçu, commande dans laquelle, lorsqu'un commutateur du laser dans le chemin de protection est dans un état sous tension, l'élément chauffant dans le chemin de protection est dans un état hors tension, et lorsqu'un commutateur du laser dans le chemin de protection est dans un état hors tension, l'élément chauffant dans le chemin de protection est dans un état sous tension, de façon à ce que la température du laser dans le chemin de protection reste stable.

12. Système selon l'une quelconque des revendications 9 à 11, dans lequel le dispositif de commande fournit un courant de commande de l'élément chauffant et un courant de commande du laser.

13. Procédé selon l'une quelconque des revendications 9 à 12, dans lequel un rapport entre une valeur pour le courant de commande de l'élément chauffant et une valeur pour le courant de commande du laser est un seuil prédéterminé.

14. Système de contrôle de décalage de longueur d'onde, comprenant :
une commande d'accès au support, MAC,
un dispositif de commande et un transmetteur, ce transmetteur comprenant un laser, un élément chauffant et un amplificateur optique, le laser étant disposé adjacent à l'élément chauffant et à l'amplificateur optique afin de permettre le transfert de chaleur au laser, et la chaleur conduite par l'élément chauffant jusqu'au laser lorsqu'un commutateur de commande d'élément chauffant de l'élément chauffant est mis sous tension correspondant à la chaleur conduite par l'amplificateur optique jusqu'au laser lorsqu'un commutateur de commande de l'amplificateur optique est mis sous tension ; la MAC étant configurée de façon à : générer un signal de commande par salves, et envoyer ce signal de commande par salves au dispositif de commande ; et
le dispositif de commande étant configuré de façon à commander un commutateur de commande d'élément chauffant pour l'élément chauffant et un commutateur de commande pour l'amplificateur optique en fonction du signal de commande par salves reçu, commande dans laquelle, lorsque le commutateur de commande d'élément chauffant de l'élément chauffant est dans un état sous tension, le commutateur de commande de l'amplificateur optique est dans un état hors tension, et lorsque le commutateur de commande d'élément chauffant de l'élément chauffant est dans un état hors tension, le commutateur de commande de l'amplificateur optique est dans un état sous tension, de façon à ce que la température du laser reste stable, et dans laquelle le commutateur de commande de l'amplificateur optique (9043) et le commutateur de commande d'élément chauffant de l'élément chauffant (9042) sont tous les deux commandés en utilisant le haut niveau ou le bas niveau du signal de commande par salves pour faire en sorte que l'amplificateur optique (9543) et l'élément chauffant (9042) fonctionnent tour à tour, maintenant ainsi la température du laser essentiellement constante, et contrôlant ainsi le décalage de longueur d'onde du laser.

15. Système selon la revendication 14, dans lequel le dispositif de commande (302) fournit un courant de commande de l'élément chauffant (3032) et un courant de commande de l'amplificateur optique (9043).

16. Système selon la revendication 14 ou 15, dans lequel un rapport entre une valeur pour le courant de commande de l'élément chauffant (3032) et une valeur pour le courant de commande de l'amplificateur optique (9043) est un seuil prédéterminé.
